# EUROPÄISCHE PATENTSCHRIFT

(11) **EP 2 283 402 B1**
(45) Veröffentlichungstag und Bekanntmachung des Hinweises auf die Patenterteilung: **17.09.2014**
(21) Anmeldenummer: 09745593.5
(22) Anmeldetag: 06.03.2009
(51) Int. Cl.: G05B 19/042

(54) **VERFAHREN ZUM STEUERN EINES ZUGRIFFS AUF BEREICHE EINES SPEICHERS AUS MEHREREN PROZESSEN HERAUS UND KOMMUNIKATIONS-MODUL MIT EINEM NACHRICHTEN-SPEICHER ZUR REALISIERUNG DES VERFAHRENS**
METHOD FOR CONTROLLING ACCESS TO REGIONS OF A STORAGE COMPRISING A PLURALITY OF PROCESSES AND COMMUNICATION MODULE HAVING A MESSAGE STORAGE FOR IMPLEMENTING THE METHOD
PROCÉDÉ POUR COMMANDER L'ACCÈS À DES ZONES D'UNE MÉMOIRE À PARTIR DE PLUSIEURS PROCESSUS ET MODULE DE COMMUNICATION MUNI D'UNE MÉMOIRE DE MESSAGES POUR LA RÉALISATION DE CE PROCÉDÉ

(30) Priorität: 14.05.2008 DE 102008001739
(43) Veröffentlichungstag der Anmeldung: 16.02.2011
(73) Patentinhaber: Robert Bosch GmbH, 70442 Stuttgart (DE)
(72) Erfinder: HARTWICH, Florian, 72762 Reutlingen (DE)
(86) Internationale Anmeldenummer: PCT/EP2009/052652
(87) Internationale Veröffentlichungsnummer: WO 2009/138260

(56) Entgegenhaltungen:
- DE-A1- 19 529 718
- DE-A1-102005 048 584

## Beschreibung

### Stand der Technik

Die vorliegende Erfindung betrifft ein Verfahren zum Steuern eines Zugriffs auf Bereiche eines Speichers aus mehreren Prozessen heraus. Die Erfindung betrifft außerdem ein an ein Kommunikations-Medium angeschlossenes Kommunikations-Modul eines Teilnehmers eines Kommunikations-Systems, wobei das Modul einen Nachrichten-Speicher zum Zwischenspeichern von über das Medium empfangenen oder über das Medium zu sendenden Nachrichten aufweist.

Aus dem Stand der Technik gibt es viele unterschiedliche Anwendungen, in denen verschiedene Prozesse denselben Speicher verwenden, um Daten untereinander auszutauschen. Ein Beispiel für solche Prozesse sind eine zentrale Verarbeitungseinheit (Central Processing Unit; CPU) und ein beliebiges Peripherie-Gerät, die beide auf denselben Speicher mit wahlfreiem Zugriff (Random Access Memory, RAM) zugreifen, um Daten zwischen CPU und Peripherie-Gerät auszutauschen.

Wenn bei einem Zugriff auf denselben Nachrichtenspeicher aus mehreren Prozessen heraus die auszutauschenden Daten nicht nur als einzelne Speicher-Worte vorliegen, sondern als Daten-Pakete mit jeweils mehreren Worten, gewinnt die Frage der Datenkonsistenz und -integrität an Bedeutung. Die Daten-Konsistenz ist dann verletzt, wenn beispielsweise ein Prozess ein bestimmtes Daten-Paket liest, während ein anderer Prozess dasselbe Daten-Paket verändert. Der lesende Prozess kann in einem solchen Fall ein Daten-Paket erhalten, das aus einer Mischung von alten und neuen Speicher-Worten besteht. Das kann zu gravierenden Problemen bei der Weiterverarbeitung des Inhalts der Daten-Pakete führen.

Um dies zu vermeiden, sind aus dem Stand der Technik Verfahren bekannt, in denen einer der beiden Prozesse vor einem Zugriff auf ein Daten-Paket den anderen Prozess beobachtet und gegebenenfalls darauf wartet, bis dieser seinen Zugriff beendet hat. Alternativ dazu kann auch ein Prozess Zugriffe des anderen Prozesses blockieren, was aber zu Datenverlusten führen kann, wenn der blockierte Prozess seine Daten nicht ablegen kann, bevor sein Zwischenspeicher für andere Aufgaben verwendet werden muss. Es sind darüber hinaus auch andere Verfahren bekannt, in denen mindestens einer der beiden Prozesse nur indirekt auf den Speicher zugreift, wobei ein eigenes Speicher-Verwaltungs-Steuerwerk die Daten-Pakete in konsistenter Form im Speicher ablegt und daraus abholt. Das ist jedoch relativ aufwendig und teuer. Diese bekannten Verfahren können kombiniert werden mit einer mehrfachen Speicherung der Daten-Pakete.

Aus dem Stand der Technik ist des Weiteren ein Kommunikations-Modul in Form eines sog. FlexRay Communication Controllers (CC) bekannt. Das Kommunikations-Modul dient zur Kopplung des FlexRay-Kommunikations-Mediums, über das Nachrichten übertragen werden, also des Datenbusses, mit einem FlexRay-Teilnehmer. Ein entsprechender Kommunikations-Controller insbesondere für den Einsatz in FlexRay ist beispielsweise in der DE 10 2005 034 744 A1 beschrieben. Zur Übertragung der Nachrichten zwischen dem Teilnehmer und dem Kommunikations-Medium ist in dem Kommunikations-Controller eine in besonderer Weise ausgebildete Anordnung zur Speicherung der Nachrichten vorgesehen. Die Nachrichtenübertragung bzw. die Verwaltung des Speichers wird durch eine Zustandsmaschine gesteuert.

In dem aus dem Stand der Technik bekannten Kommunikations-Controller sind zwei sogenannte Transiente Buffer (TBF), einer für den Kanal A und ein anderer für den Kanal B, vorgesehen. Jeder Transiente Buffer kann zwei Nachrichten speichern, nämlich eine Rx (Receive)-Nachricht und eine Tx (Transmit)-Nachricht. Der Schnittstellenbaustein umfasst des Weiteren einen sogenannten Input Buffer (IBF) und einen Output Buffer (OBF), die jeweils eine Kapazität von zwei Nachrichten haben.

Auf die Transienten Buffer (TBF) wird zum einen aus dem Kommunikations-Medium heraus und zum anderen über einen sogenannten Message Handler des FlexRay Kommunikations-Controllers zugegriffen. Auf die Input bzw. Output Buffer (IBF; OBF) wird zum einen durch die Host-CPU des Teilnehmers und zum anderen durch den Message Handler zugegriffen. Beim Zugriff auf die genannten Buffer des Kommunikations-Controller aus den genannten Prozessen heraus ist die Erhaltung der Datenkonsistenz und -integrität eine ganz wichtige Voraussetzung. Aus diesem Grund hat bei dem bekannten Kommunikations-Controller die Host-CPU keinen direkten Zugriff auf die Nachrichtenspeicher (IBF; OBF). Die Input bzw. Output Buffer haben vielmehr zwei voneinander getrennte Speicherblöcke (sogenanntes IBF und IBF Shadow bzw. OBF und OBF Shadow). Zum Senden von Daten schreibt die Host-CPU Daten in den Input Buffer und initiiert dann eine Nachrichtenübertragung. Daraufhin wird der Inhalt des IBF und des IBF-Shadows vertauscht. Danach beginnt die Übermittlung der Daten von dem IBF Shadow in den Nachrichtenspeicher (sogenannten Message RAM). Die Host-CPU kann die Daten der nachfolgenden Nachricht bereits in den Input Buffer (IBF) schreiben, während die Datenübermittlung von dem IBF-Shadow in den Message RAM noch läuft. Die Daten aus dem Message RAM werden dann über das Kommunikations-Medium an andere Teilnehmer übertragen. Nach Beendigung der Datenübermittlung zwischen dem IBF-Shadow und dem Message RAM wird der Inhalt von IBF und IBF-Shadow wiederum vertauscht und so weiter.

Durch diese relativ aufwendige Maßnahme kann zwar die Datenintegrität gewahrt werden, die Maßnahme kostet allerdings sehr viel Chipfläche, da die Nachrichtenspeicher (IBF; OBF) jeweils doppelt ausgeführt werden müssen. Weitere Nachteile des bekannten Kommunikations-Controllers bestehen darin, dass der Message Handler ein relativ großer und damit teurer Zustandautomat (sogenannte State Machine) ist. Außerdem führt das beschriebene Verfahren dazu, dass in dem Nachrichtenspeicher (Message RAM) sowohl aktuelle als auch ältere Daten abgelegt sind. Zudem gestaltet sich der Zugriff der Host-CPU auf den Nachrichtenspeicher (Message RAM) über den Input bzw. Output Buffer (IBF; OBF) relativ aufwendig, da ein direkter Zugriff nicht möglich ist, sondern lediglich ein indirekter Zugriff über IBF Shadow bzw. OBF Shadow.

Die Offenlegungsschrift DE 195 29 718 A1 offenbart eine Pufferschaltung zum Zwischenspeichern von Daten mit einer Auswahlschaltung und jeweils mindestens drei Eingangs- und Ausgangssignalspeicherbereichen. Der Auswahlschaltung wird mitgeteilt, wann ein Schreib-bzw. Lesevorgang beginnt oder endet. Die Auswahlschaltung gewährleistet, dass von den beteiligten Prozessen Daten jeweils aus dem gewünschten Speicherbereich ausgelesen wird. Ein erster Prozess, der auf einer übergeordneten Recheneinheit abläuft, modifiziert hierzu mittels der Auswahlschaltung das Adressbus-Signal, mit welchem ein anderer Prozess, der auf einer intelligenten Einheit der Peripherie abläuft, auf einen Speicherbereich zugreift. Hierzu ist die Auswahlschaltung über Steuerleitungen mit einer Busschnittstelle verbunden. Die übergeordnete Recheneinheit greift über die Busschnittstelle auf die Pufferschaltung zu und beeinflusst die Steuerleitungen.

Ausgehend von dem beschriebenen Stand der Technik liegt der vorliegenden Erfindung die Aufgabe zugrunde, den Zugriff mehrerer Prozesse auf denselben Speicher zu vereinfachen, insbesondere zu beschleunigen, und eine kostengünstige Realisierung zu ermöglichen, wobei gleichzeitig die Datenintegrität gewährleistet sein muss.

Zur Lösung dieser Aufgabe wird ausgehend von dem Verfahren zum Steuern eines Zugriffs auf Speicherbereiche der eingangs genannten Art vorgeschlagen, dass ein erster der Prozesse einen Teil eines Adress-Busses steuert, mit dem ein anderer der Prozesse auf den Speicher zugreift, wobei durch die Steuerung des Teils des Adress-Busses der erste Prozess Einfluss darauf nimmt, auf welchen Speicherbereich der andere Prozess zugreift, wobei in dem Speicher Daten-Pakete abgelegt werden. Das Verfahren ist dadurch gekennzeichnet, dass der erste Prozess einen Teil des Adress-Busses über Kontroll-Register steuert, wobei für jedes in dem Speicher abgelegte Daten-Paket ein Kontroll-Register vorgesehen ist, wobei die Kontroll-Register zweistufig ausgebildet sind, wobei der erste Prozess jederzeit in die erste Stufe des Kontroll-Registers schreiben kann.

### Offenbarung der Erfindung

Erfindungsgemäß wird also ein Verfahren vorgeschlagen, wie ein Prozess den Zugriff des anderen Prozesses auf ein in dem Speicher gespeichertes Daten-Paket so steuern kann, dass beide Prozesse ohne Daten-Verlust und ohne Wartezeiten auf die jeweils neuesten gültigen Daten-Pakete zugreifen können. Das erfindungsgemäße Verfahren eignet sich sowohl für Speicher, auf die mehrere Prozesse, insbesondere zwei Prozesse, gleichzeitig (Dual-Ported RAM) zugreifen können, als auch für Speicher, auf die aus mehreren Prozessen heraus abwechselnd, insbesondere im Zeitmultiplex, zugegriffen wird (sogenannte Single-Ported RAM). Das Verfahren kann nicht nur für solche Speicher eingesetzt werden, auf die zwei Prozesse auf denselben Speicher zugreifen, sondern auch für solche Verfahren, in denen mehr als zwei Prozesse auf denselben Speicher zugreifen.

Bei dem erfindungsgemäßen Verfahren steuert einer der Prozesse einen Teil des Adress-Busses, mit dem ein anderer Prozess auf den Speicher zugreift. Die Steuerung des Adress-Busses durch den ersten Prozess kann beispielsweise über schreibbare Kontroll-Register erfolgen. Dadurch wird eine einfach und kostengünstig zu realisierende Möglichkeit vorgeschlagen, wie beide bzw. alle Prozesse ohne Wartezeiten auf denselben Speicher zugreifen können, ohne dass Daten-Pakete verloren gehen und ohne dass es eines aufwendigen Speicher-Verwaltungs-Steuerwerks bedarf.

Bei dem Verfahren sind vorzugsweise alle Daten-Pakete gleich groß. Insbesondere umfassen alle Daten-Pakete 2ⁿ Speicher-Worte. Falls das nicht der Fall ist, werden die Daten-Pakete vorzugsweise in zwei Teile aufgespalten, in einen sogenannten Kopfteil, der eine feste Größe, insbesondere 2ⁿ Speicher-Worte, hat, und in einen Hauptteil, dessen Größe variabel ist. Der Kopfteil enthält einen Zeiger auf den Hauptteil, der in demselben oder einem anderen Speicher abgelegt sein kann. Die Daten-Pakete bzw. die Kopfteile der Daten-Pakete werden vorzugsweise in jeweils mindestens zwei Versionen in dem Speicher abgelegt.

Bei dem erfindungsgemäßen Verfahren kann ein erster Prozess auf alle Speicherbereiche des Speichers zugreifen. Außerdem kann der erste Prozess das Adress-Bus-Signal, mit dem ein weiterer Prozess auf denselben Speicher zugreift, modifizieren. Dies gilt nur für den Zugriff auf Daten-Pakete gleicher Größe bzw., wenn die Daten-Pakete in Kopfteil und Hauptteil aufgespalten sind, für den Zugriff auf Kopfteile gleicher Größe. Der Zugriff auf den Hauptteil der Daten-Pakete wird nicht modifiziert, sondern erfolgt über den im entsprechenden Kopfteil abgelegten Zeiger auf den Hauptteil.

Der weitere Prozess, der auf eines von bis zu 2^{m} Daten-Pakete oder auf 2^{m} Kopfteile von Daten-Paketen bestehend aus jeweils 2ⁿ Speicher-Worten zugreift, produziert ein Adress-Signal einer bestimmten Bitlänge. Bei einer Größe der Daten-Pakete bzw. der Kopfteile der Daten-Pakete von 2ⁿ Speicher-Worten und einem Zugriff des weiteren Prozesses auf bis zu 2^{m} Daten-Pakete bzw. 2^{m} Kopfteile von Daten-Paketen hat das Adress-Signal des zweiten Prozesses eine Länge vom (m + n) Bit. Der weitere Prozess kann mittels des von ihm generierten Adress-Signals jedoch nicht zwischen den Adressen eines mehrfach gespeicherten Daten-Pakets, d. h. zwischen den verschiedenen Versionen des Daten-Pakets, unterscheiden. Dazu bedarf es zusätzlicher Adress-Bits, die von dem ersten Prozess zur Verfügung gestellt werden. Vorteilhafterweise kommen die zusätzlichen Adress-Bits von einem Kontroll-Register, das von dem ersten Prozess gesteuert wird. Mit k zusätzlichen Bits wird zwischen 2^{k} gespeicherten Versionen eines bestimmten Daten-Pakets bzw. eines Kopfteils eines bestimmten Daten-Pakets unterschieden. Dadurch ergibt sich ein Adress-Signal von insgesamt (m + n + k) Bit. Die Positionen der drei Bit-Gruppen in dem Adress-Signal sind beliebig.

Die Unteransprüche enthalten vorteilhafte Ausgestaltungen des erfindungsgemäßen Verfahrens. Besondere Merkmale und Vorteile der vorliegenden Erfindung werden nachfolgend unter Bezugnahme auf die Figuren näher erläutert. Es zeigen:
- Figur 1: einen Speicher mit verschiedenen Bereichen, auf die aus mehreren Prozessen heraus zugegriffen werden kann;
- Figur 2: ein Beispiel für den Inhalt eines Speichers, wobei der Zugriff auf Bereiche des Speichers nach dem erfindungsgemäßen Verfahren gesteuert wird;
- Figur 3: ein schematisches Blockschaltbild zur Erläuterung des erfindungsgemäßen Verfahrens; und
- Figur 4: ein Kommunikations-System mit mehreren an ein Kommunikations-Medium angeschlossenen Kommunikations-Teilnehmern, jeweils mit einem Kommunikations-Controller mit einem Nachrichtenspeicher, auf den nach dem erfindungsgemäßen Verfahren aus verschiedenen Prozesses heraus zugegriffen werden kann.

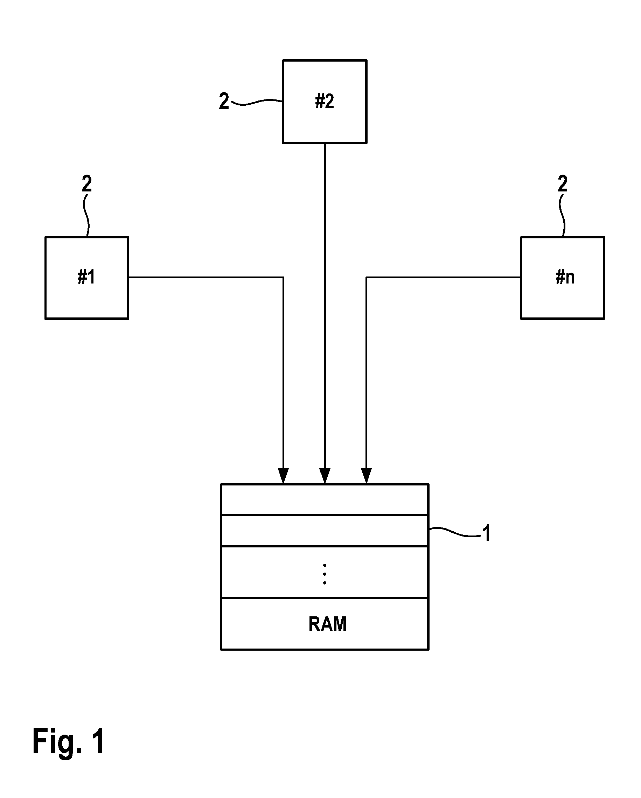

In Figur 1 ist ein Speicher 1 dargestellt, der beispielsweise als ein Speicher mit wahlfreiem Zugriff (Random Access Memory; RAM) ausgebildet ist. Insbesondere kann der Speicher als ein Dual-Ported RAM oder als ein Single-Ported RAM ausgebildet sein. Selbstverständlich kann der Speicher 1 auch als ein beliebig anderer flüchtiger oder nicht flüchtiger beschreibbarer Speicher ausgebildet sein. Mehrere Prozesse (#1, #2, #n) 2 können auf Bereiche des Speichers 1 zugreifen. Der Zugriff auf die Speicherbereiche umfasst insbesondere einen schreibenden und/oder einen lesenden Zugriff auf den Speicher 1. Die Prozesse 2 umfassen beispielsweise eine zentrale Verarbeitungseinheit (Central Processing Unit; CPU) und beliebige Peripherie-Geräte, die auf Bereiche desselben Speichers 1 zugreifen können.

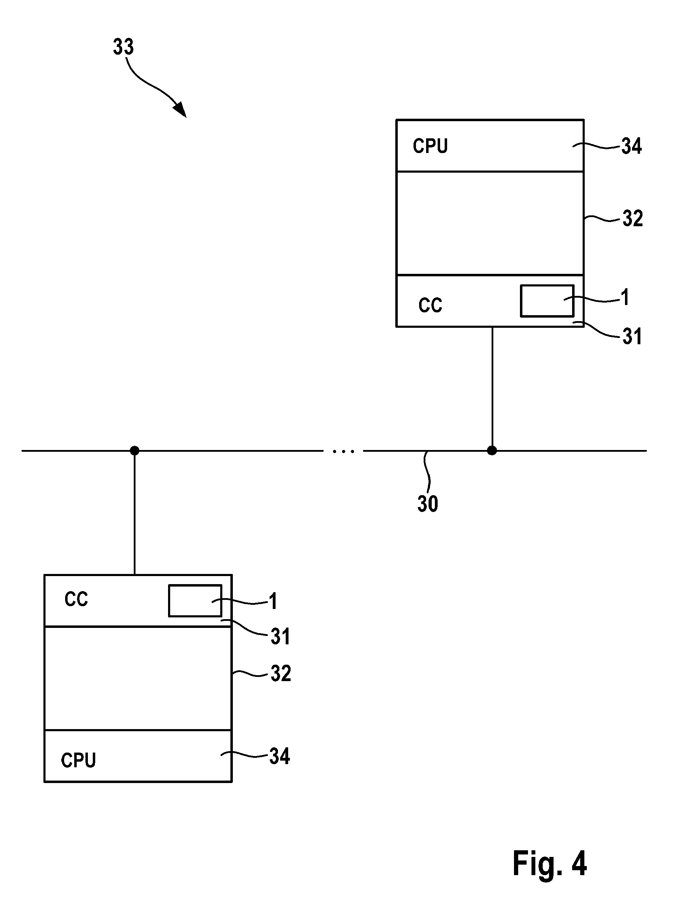

Der Speicher 1 kann auch - wie beispielhaft in Figur 4 dargestellt - Teil eines Kommunikations-Controllers (CC) 31 eines Kommunikations-Teilnehmers 32 eines Kommunikations-Systems 33, z. B. eines FlexRay-Netzwerks, eines CAN-Netzwerks oder eines TTCAN-Netzwerks, sein. Dabei kann auf den Speicher 1 einerseits über ein Kommunikations-Medium 30 (z. B. FlexRay-Bus, CAN-Bus, TTCAN-Bus) und andererseits von einem Host-Prozessor 34 (Host-CPU) des Kommunikations-Teilnehmers 32 heraus, dem der Kommunikations-Controller 31 zugeordnet ist, zugegriffen werden.

Die Prozesse 2 nutzen den Zugriff auf den gemeinsamen Speicher 1 insbesondere zum Austausch von Daten. Wenn die auszutauschenden Daten nicht nur als einzelne Speicher-Worte vorliegen, sondern als Daten-Pakete, die mehrere Worte umfassen, rückt die Frage der Daten-Integrität, insbesondere der Daten-Konsistenz in den Vordergrund. Ein Speicher-Wort ist die systembedingte Speichereinheit einer bestimmten Verarbeitungseinheit. Ein Wort ist die größte Datenmenge, die von einem Prozessor der Verarbeitungseinheit in einem Verarbeitungsschritt ausgeführt werden kann, und entspricht meist der Breite des Hauptdatenbusses. Typische Wortbreiten sind 16 und 32 Bit. Die Konsistenz der in dem Speicher 1 abgelegten Daten wäre verletzt, wenn beispielsweise ein Prozess #1 ein bestimmtes Daten-Paket liest, während ein anderer Prozess #2 das gleiche Daten-Paket verändert. Der lesende Prozess #1 könnte dann ein Paket erhalten, das aus einer Mischung von alten und neuen Daten-Worten besteht. Um dies zu vermeiden, wird erfindungsgemäß ein Verfahren vorgeschlagen, wie ein Prozess 2 den Zugriff eines anderen Prozesses 2 auf ein in dem Speicher 1 gespeichertes Daten-Paket so steuern kann, dass beide Prozesse ohne Daten-Verlust und ohne Wartezeiten auf die jeweils neuesten gültigen Daten-Pakete zugreifen können. Das Verfahren eignet sich sowohl für Speicher 1, auf die zwei oder mehr Prozesse 2 gleichzeitig zugreifen können (Dual-Ported RAM), als auch für Speicher 1, auf die abwechselnd, vorzugsweise im Zeitmultiplex, zugegriffen wird (Single-Ported RAM).

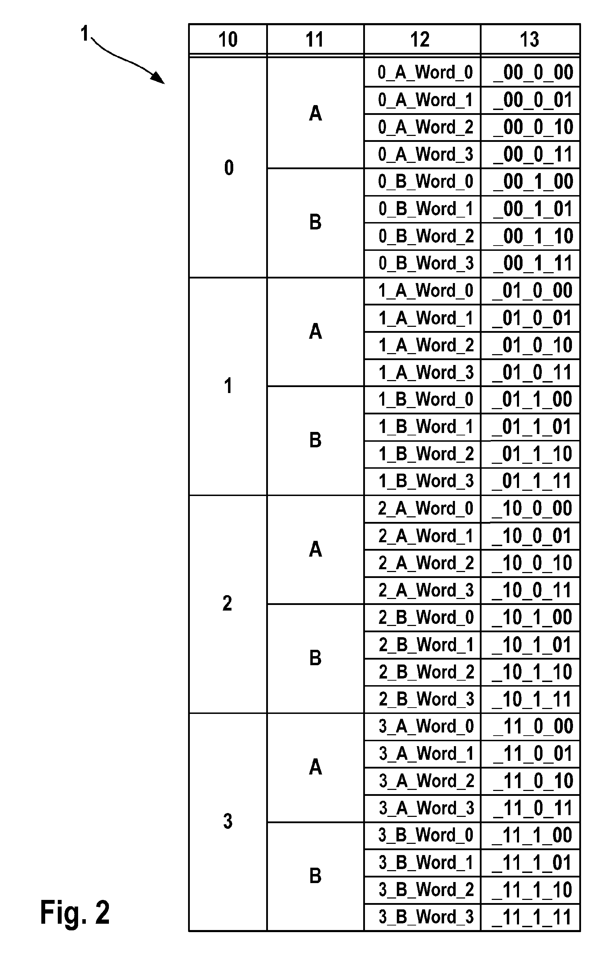

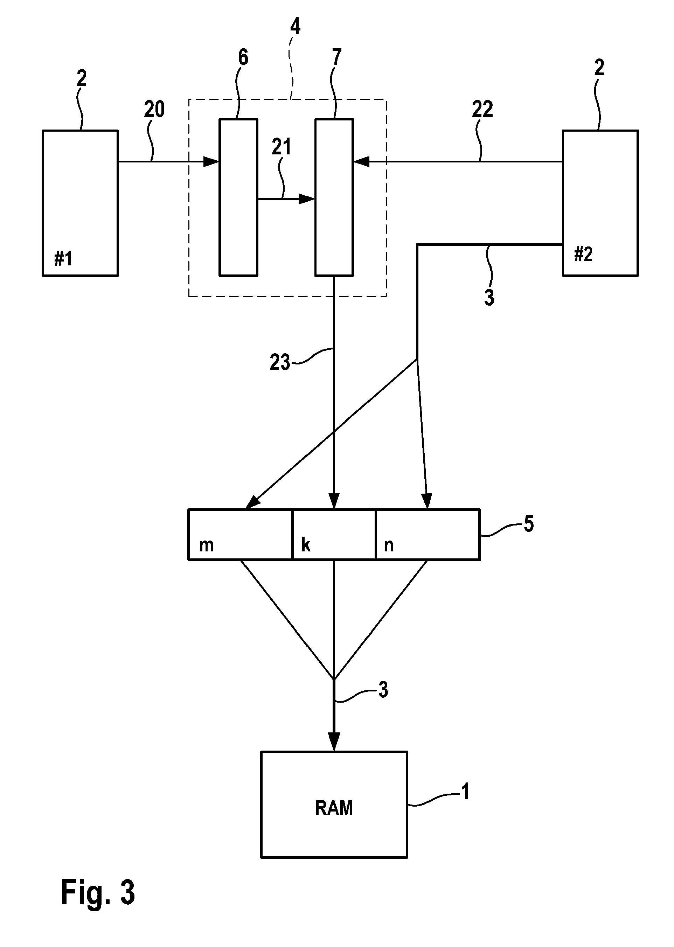

Das erfindungsgemäße Verfahren wird nachfolgend im Detail unter Bezugnahme auf die Figuren 2 und 3 näher erläutert. Bei dem Verfahren steuert einer der Prozesse #1, beispielsweise eine CPU, einen Teil des Adress-Busses 3, mit dem ein anderer Prozess #2, beispielsweise ein Peripherie-Modul, auf den Speicher 1 zugreift. Die Steuerung des Adress-Busses durch den ersten Prozess #1 erfolgt vorzugsweise über schreibbare Kontroll-Register 4. Das erfindungsgemäße Verfahren hat den Vorteil, dass beide Prozesse #1, #2 (bzw. alle Prozesse 2, die auf den Speicher 1 zugreifen können) ohne Wartezeiten auf den Speicher 1 zugreifen können, dass keine Daten-Pakete verloren gehen, und dass kein aufwendiges Speicher-Verwaltungs-Steuerwerk benötigt wird.

Die in dem Speicher 1 abgelegten Daten-Pakete sind alle gleich groß. Vorzugsweise umfassen die Daten-Pakete 2ⁿ Speicher-Worte. Falls die Daten-Pakete nicht gleich groß sind, werden sie in zwei Teile aufgespalten, nämlich in einen Kopfteil, der eine feste Größe hat, und in einen Hauptteil, dessen Größe variabel ist. Die Größe des Kopfteils beträgt vorzugsweise 2ⁿ Speicher-Worte. Der Kopfteil enthält einen Zeiger auf den Hauptteil, der sich im gleichen Speicher 1 oder in einem anderen Speicher befinden kann. Die Daten-Pakete werden in jeweils mindestens zwei verschiedenen Versionen A, B im Speicher 1 abgelegt. In Figur 2 ist ein Beispiel für die Verwaltung der Daten in dem Speicher 1 dargestellt, der insgesamt 32 Speicher-Worte umfasst, die mit einem fünf Bit breiten Vektor adressiert werden. Der Speicher 1 umfasst vier (= 2²) Daten-Pakete (m = 2) in je zwei (= 2¹) Versionen (k = 1) mit je vier (= 2²) Daten-Worten (n = 2) .

Bei dem erfindungsgemäßen Verfahren kann der erste Prozess #1 auf alle Teile des Speichers 1 zugreifen. Außerdem kann der erste Prozess #1 das Adress-Bus-Signal (auf dem Adress-Bus 3), mit dem der zweite Prozess #2 auf den Speicher 1 zugreift, modifizieren. Dies gilt für den Zugriff auf die Daten-Pakete gleicher Größe bzw., falls die Daten-Pakete in Kopfteil und Hauptteil aufgespalten sind, auf die Kopfteile der Daten-Pakete. Der Zugriff auf den Hauptteil der Pakete wird nicht modifiziert.

Der zweite Prozess, der auf eines von bis zu 2^{m} Daten-Pakete (bzw. auf einen von bis zu 2^{m} Kopfteilen von Daten-Paketen) umfassend jeweils zwei 2ⁿ Speicher-Worte zugreift, erzeugt ein Adress-Bus-Signal der Länge (m + n) Bits. Über dieses Signal am Adress-Bus 3 kann der zweite Prozess #2 auf ein bestimmtes Daten-Wort eines bestimmten Daten-Pakets bzw. auf den entsprechenden Bereich in dem Speicher 1 zugreifen. Der zweite Prozess #2 kann mittels dieses Adress-Bus-Signals jedoch nicht zwischen den Adressen eines mehrfach gespeicherten Daten-Pakets, d. h. zwischen den verschiedenen Versionen des Daten-Pakets, unterscheiden. Die zusätzlichen Adress-Bits, die hierfür erforderlich sind, kommen von dem Kontroll-Register 4, das von dem ersten Prozess #1 gesteuert wird. Mit k zusätzlichen Bits wird zwischen 2^{k} gespeicherten Versionen eines bestimmten Daten-Pakets unterschieden. Dadurch ergibt sich insgesamt ein Adress-Bus-Signal 5 von (m + n + k) Bit Länge. Dabei sind die Positionen der drei Bit-Gruppen im Adress-Signal 5 beliebig. In dem Speicher 1, dessen Verwaltung in Figur 2 wiedergegeben ist, sind - wie gesagt - vier Daten-Pakete (m = 2) mit jeweils vier Daten-Worten (n = 2) in zwei verschiedenen Versionen (k = 1) je Daten-Paket abgelegt. In Figur 2 ist die Spalte "Daten-Paket" mit dem Bezugszeichen 10, die Spalte "Version" mit dem Bezugszeichen 11, die Spalte "Speicher-Wort" mit dem Bezugszeichen 12 und die Spalte "Adresse" mit dem Bezugszeichen 13 bezeichnet. In dem Speicher 1 ist also Platz für insgesamt 32 Speicher-Worte, die über einen fünf Bit breiten Vektor adressiert werden können. Die Adresse setzt sich aus den Bits (m_k_n) zusammen.

Für jedes der in dem Speicher 1 enthaltenen Daten-Pakete gibt es ein k Bit breites zweistufiges Kontroll-Register 4, mit dem der erste Prozess #1 einstellen kann, auf welche Version des gewünschten Daten-Pakets der andere Prozess #2 zugreifen kann (bzw. soll). Das Register 4 ist vorzugsweise mehrstufig, insbesondere zweistufig ausgebildet. In dem beschriebenen Ausführungsbeispiel gibt es also insgesamt vier k Bit breite zweistufige Register 4. Die zwei Stufen in dem Register 4 sind mit den Bezugszeichen 6 und 7 bezeichnet. Der erste Prozess #1 kann eine bestimmte Version 11 eines Daten-Pakets auswählen, auf das der zweite Prozess #2 zugreifen darf, oder lediglich ein Steuer-Signal zum Umschalten auf die nächste verfügbare Version 11 geben. Der erste Prozess #1 kann auf die erste Stufe 6 des Registers 4 schreiben (Bezugszeichen 20), nicht jedoch auf die zweite Stufe 7 des Registers 4. Nach dem Beschreiben der ersten Stufe 6 durch den ersten Prozess #1 werden die Daten aus der ersten Stufe 6 vorzugsweise sofort in die zweite Stufe 7 kopiert (Bezugszeichen 21), wenn der andere Prozess #2 die zweite Stufe 7 nicht verriegelt (Bezugszeichen 22). Der Ausgang der zweiten Stufe 7 wird dann in das Adress-Bus-Signal 5 eingefügt (Bezugszeichen 23). Wenn die zweite Stufe 7 des Registers 4 verriegelt ist, werden die Daten aus der ersten Stufe 6 erst nach der Entriegelung in die zweite Stufe 7 kopiert. Es ist denkbar, dass auch der erste Prozess #1 über ein modifiziertes Adress-Bus-Signal auf die Daten-Pakete in dem Speicher 1 zugreift, dann allerdings nicht auf die gleiche Version wie der zweite Prozess #2.

In der Handhabung des erfindungsgemäßen Verfahrens wird unterschieden zwischen den Daten-Paketen, die von dem ersten Prozess #1 zum zweiten Prozess #2 gehen, und den Daten-Paketen, die in der Gegenrichtung von dem zweiten Prozess #2 zu dem ersten Prozess #1 gehen.

Zunächst wird der Ablauf des erfindungsgemäßen Verfahrens für Daten-Pakete beschrieben, die von dem ersten Prozess #1 zu dem zweiten Prozess #2 gehen. Zunächst schreibt der erste Prozess #1 seine Daten in eine bestimmte Version 11 eines bestimmten Daten-Pakets 10, die für den zweiten Prozess #2 nicht zugänglich ist und schaltet sofort danach den Zugang des zweiten Prozesses #2 auf diese Version 11 des Daten-Pakets 10 um.

Der zweite Prozess #2, der ein Daten-Paket 10 ausliest, verriegelt (22) zuerst die zweite Stufe 7 des Kontroll-Registers 4 für dieses Paket 10, liest dann im Block-Transfer die ihm zugängliche Version 11 des betreffenden Daten-Pakets 10 (gegebenenfalls Kopfteil und Hauptteil) aus und entriegelt (22) die zweite Stufe 7 zum Abschluss des Block-Transfers.

Falls der Schreib-Zugriff des ersten Prozesses #1 und der Lese-Zugriff des zweiten Prozesses #2 sich zeitlich überlappen, liest der zweite Prozess #2 konsistente Daten aus der älteren Version 11 des Daten-Pakets 10. Dieses Verhalten ist besonders wichtig, falls es sich bei dem zweiten Prozess #2 um einen zeitgesteuerten Kommunikations-Controller (CC) 31 handelt (z. B. einen TTCAN-CC oder einen FlexRay-CC). Hier wird der Zeitpunkt, zu dem ein Daten-Paket 10 ausgelesen werden muss, von dem Kommunikations-System 33 vorgegeben. Mit dem Lese-Zugriff des Kommunikations-Controllers 31 auf das Daten-Paket 10 kann in zeitgesteuerten Kommunikations-Systemen 33 also nicht gewartet werden, bis der erste Prozess #1 seinen Schreib-Zugriff beendet hat.

Es wird hier davon ausgegangen, dass der erste Prozess #1 die Daten nicht schneller in die dafür vorgesehenen Speicherbereiche schreibt, als sie von dem zweiten Prozess #2 abgeholt werden können. Optional besteht die Möglichkeit, dass der zweite Prozess # 2 dem ersten Prozess #1 signalisiert, ob er die Daten aus einem bestimmten Speicherbereich nach dem letzten Umschalten der Paket-Versionen 11 mindestens einmal abgeholt hat.

Wenn die Daten von dem zweiten Prozess #2 zu dem ersten Prozess #1 übermittelt werden sollen, liest zunächst der erste Prozess #1 die Daten, die er von dem zweiten Prozess #2 erwartet, aus der Version 11 des Daten-Pakets 10, die für den zweiten Prozess #2 nicht zugänglich ist, und schaltet unmittelbar danach den Zugang des zweiten Prozesses #2 auf diese Version 11 des Pakets 10 um.

Der zweite Prozess #2, der ein Daten-Paket 10 schreibt, verriegelt (22) zuerst die zweite Stufe 7 des Kontroll-Registers 4 für dieses Paket 10, schreibt dann im Block-Transfer das Paket 10 (gegebenenfalls Kopfteil und Hauptteil) und entriegelt (22) die zweite Stufe 7 zum Abschluss des Block-Transfers.

Falls der Lese-Zugriff des ersten Prozesses #1 und der Schreib-Zugriff des zweiten Prozesses #2 sich zeitlich überlappen, liest der erste Prozess #1 konsistente Daten aus der älteren Version 11 des Pakets 10. Dieses Verhalten ist besonders wichtig, wenn der Zeitpunkt, zu dem der zweite Prozess #2 neue Daten-Pakete ablegt, nicht unter der Kontrolle des ersten Prozesses #1 steht.

Es wird hier davon ausgegangen, dass der erste Prozess #1 die Daten schnell genug abholt, so dass nicht beide Versionen 11 eines Daten-Pakets 10 ungelesene Daten enthalten können. Optional ist es denkbar, dass der zweite Prozess #2 dem ersten Prozess #1 signalisiert, ob er die Daten eines bestimmten Daten-Pakets 10 seit dem letzten Umschalten der Paket-Versionen 11 erneuert hat und ob die Daten seit dem letzten Umschalten mehrfach erneuert wurden, was einen Datenverlust bedeuten kann.

Das erfindungsgemäße Speicher-Verwaltungs-Verfahren ist insbesondere für Nachrichten-Speicher in Hardware-Kommunikations-Modulen 31 von Kommunikations-Teilnehmern 32 eines Kommunikations-Systems (z.B. FlexRay, CAN, TTCAN) einsetzbar. Eine Anwendung in anderen Peripherie-Modulen ist ebenfalls möglich und vorteilhaft.

## Patentansprüche

1. Verfahren zum Steuern eines Zugriffs auf Bereiche eines Speichers (1) aus mehreren Prozessen (2) heraus,
wobei ein erster (#1) der Prozesse (2) einen Teil eines Adress-Busses (3) steuert, mit dem ein anderer (#2) der Prozesse (2) auf den Speicher (1) zugreift,
wobei durch die Steuerung des Teils des Adress-Busses (3) der erste Prozess (#1) Einfluss darauf nimmt, auf welchen Speicherbereich der andere Prozess (#2) zugreift, wobei in dem Speicher (1) Daten-Pakete abgelegt werden,
**dadurch gekennzeichnet, dass** der erste Prozess (#1) einen Teil des Adress-Busses (3) über Kontroll-Register (4) steuert,
wobei für jedes in dem Speicher (1) abgelegte Daten-Paket ein Kontroll-Register (4) vorgesehen ist,
wobei die Kontroll-Register (4) zweistufig ausgebildet sind,
wobei der erste Prozess (#1) jederzeit in die erste Stufe (6) des Kontroll-Registers (4) schreiben kann.

2. Verfahren nach Anspruch 1, **dadurch gekennzeichnet, dass** in dem Speicher (1) die Daten-Pakete in jeweils mindestens zwei Versionen abgelegt werden und durch das Kontroll-Register (4) zwischen verschiedenen Versionen von Daten-Paketen unterschieden wird.

3. Verfahren nach Anspruch 1 oder 2, **dadurch gekennzeichnet, dass** der Speicher (1) als ein Dual-Ported RAM ausgebildet ist, auf das die Prozesse (#1, #2) gleichzeitig zugreifen.

4. Verfahren nach Anspruch 1 oder 2, **dadurch gekennzeichnet, dass** der Speicher (1) als ein Single-Ported RAM ausgebildet ist, auf das die Prozesse (#1, #2) abwechselnd, insbesondere im Zeitmultiplex, zugreifen.

5. Verfahren nach einem der Ansprüche 1 bis 4, **dadurch gekennzeichnet, dass** in dem Speicher (1) gleich große Daten-Pakete, insbesondere mit 2ⁿ Speicher-Worten mit *n* ∈ |N, abgelegt sind.

6. Verfahren nach einem der Ansprüche 1 bis 4, **dadurch gekennzeichnet, dass** in dem Speicher (1) beliebig große Daten-Pakete abgelegt sind, wobei die Daten-Pakete jeweils in zwei Teile aufgespalten werden, nämlich in einen Kopfteil, insbesondere mit 2ⁿ Speicher-Worten mit *n* ∈ |N, und in einen Hauptteil mit variabler Größe, wobei die Kopfteile verschiedener Daten-Pakete gleich groß sind.

7. Verfahren nach Anspruch 2, **dadurch gekennzeichnet, dass** in dem Speicher (1) Daten-Pakete in so vielen Versionen abgelegt werden, wie Prozesse (2) auf den Speicher (1) zugreifen können.

8. Verfahren nach Anspruch 2 oder 7, **dadurch gekennzeichnet, dass** der erste Prozess (#1) auf alle Bereiche des Speichers (1) zugreifen kann und ein Adress-Bus-Signal (5) modifiziert, mit dem der andere Prozess (#2) auf den Speicher (1) zugreift, wobei das unmodifizierte Adress-Bus-Signal (5) auf ein bestimmtes in dem Speicher (1) abgelegtes Daten-Paket (10) bzw. auf einen Kopfteil eines bestimmten in dem Speicher (1) abgelegten Daten-Pakets (10) verweist und das modifizierte Adress-Bus-Signal (5) auf eine bestimmte Version (11) des Daten-Pakets (10) bzw. des Kopfteils des Daten-Pakets (10) verweist.

9. Verfahren nach Anspruch 8, **dadurch gekennzeichnet, dass** das unmodifizierte Adress-Bus-Signal eine bestimmte Anzahl von Adress-Bits umfasst und der erste Prozess (#1) zur Modifikation des Adress-Bus-Signals (5) mindestens ein zusätzliches Adress-Bit zu dem unmodifizierte Adress-Bus-Signal (5) hinzufügt, durch das zwischen den verschiedenen gespeicherten Versionen (11) des Daten-Pakets (10) bzw. des Kopfteils des Daten-Pakets (10) unterschieden wird.

10. Verfahren nach Anspruch 9, **dadurch gekennzeichnet, dass** der zweite Prozess (#2) auf eines von bis zu 2^{m} in dem Speicher (1) abgelegten Daten-Paketen bzw. auf einen von bis zu 2^{m} in dem Speicher (1) abgelegten Kopfteilen von Daten-Paketen zugreift, wobei das unmodifizierte Adress-Bus-Signal (5) m+n Bits und das modifizierte Adress-Bus-Signal (5) m+n+k Bits umfasst.

11. Verfahren nacheinem der Ansprüche 1 bis 10, **dadurch gekennzeichnet, dass** der zweite Prozess (#2) die zweite Stufe (7) des Kontroll-Registers (4) bei Bedarf verriegelt, so dass ein Kopieren des Inhalts der ersten Stufe (6) des Kontroll-Registers (4) in die zweite Stufe (7) unterbunden wird.

12. Verfahren nach Anspruch 11, **dadurch gekennzeichnet, dass** der Inhalt der ersten Stufe (6) des Kontroll-Registers (4) in die zweite Stufe (7) des Kontroll-Registers (4) kopiert wird, wenn die zweite Stufe (7) entriegelt ist.

13. Verfahren nach Anspruch 12, **dadurch gekennzeichnet, dass** der Inhalt der zweiten Stufe (7) des Kontroll-Registers (4) in das Adress-Bus-Signal (5) eingefügt wird.

14. An ein Kommunikations-Medium (30) angeschlossenes Kommunikations-Modul (31) eines Teilnehmers (32) eines Kommunikations-Systems (33), wobei das Modul (31) einen Nachrichten-Speicher (1) zum Zwischenspeichern von über das Medium (30) empfangenen oder über das Medium zu sendenden Nachrichten aufweist, **dadurch gekennzeichnet, dass** das Kommunikations-Modul (31) Mittel zur Steuerung eines Zugriffs auf Bereiche des Nachrichten-Speichers (1) von einem Teilnehmer-Prozessor (34) aus gemäß einem Verfahren nach einem der Ansprüche 1 bis 13 aufweist.

## Claims

1. Method for controlling access to areas of a memory (1) from a plurality of processes (2),
a first (#1) of the processes (2) controlling a part of an address bus (3) which is used by another (#2) of the processes (2) to access the memory (1),
the first process (#1) influencing which memory area is accessed by the other process (#2) by controlling said part of the address bus (3),
data packets being stored in the memory (1),
**characterized in that** the first process (#1) controls a part of the address bus (3) using control registers (4),
a control register (4) being provided for each data packet stored in the memory (1),
the control registers (4) having a two-stage design,
the first process (#1) being able to write to the first stage (6) of the control register (4) at any time.

2. Method according to Claim 1, **characterized in that** the data packets are stored in at least two versions each in the memory (1) and the control register (4) distinguishes between different versions of data packets.

3. Method according to Claim 1 or 2, **characterized in that** the memory (1) is in the form of a dual-ported RAM which is accessed by the processes (#1, #2) simultaneously.

4. Method according to Claim 1 or 2, **characterized in that** the memory (1) is in the form of a single-ported RAM which is accessed by the processes (#1, #2) alternately, in particular in time division multiplexing.

5. Method according to one of Claims 1 to 4, **characterized in that** data packets of the same size, in particular with 2ⁿ memory words, where *n* ∈ |N, are stored in the memory (1).

6. Method according to one of Claims 1 to 4, **characterized in that** data packets of any desired size are stored in the memory (1), the data packets each being split into two parts, namely into a header, in particular with 2ⁿ memory words, where *n* ∈ |N, and into a main part of variable size, the headers of different data packets being of the same size.

7. Method according to Claim 2, **characterized in that** data packets are stored in the memory (1) in as many versions as processes (2) can access the memory (1).

8. Method according to Claim 2 or 7, **characterized in that** the first process (#1) can access all areas of the memory (1) and modifies an address bus signal (5) which is used by the other process (#2) to access the memory (1), the unmodified address bus signal (5) referring to a particular data packet (10) stored in the memory (1) or to a header of a particular data packet (10) stored in the memory (1), and the modified address bus signal (5) referring to a particular version (11) of the data packet (10) or the header of the data packet (10).

9. Method according to Claim 8, **characterized in that** the unmodified address bus signal comprises a particular number of address bits, and the first process (#1) adds at least one additional address bit to the unmodified address bus signal (5) for the purpose of modifying the address bus signal (5), which additional address bit is used to distinguish between the different stored versions (11) of the data packet (10) or the header of the data packet (10).

10. Method according to Claim 9, **characterized in that** the second process (#2) accesses one of up to 2^{m} data packets stored in the memory (1) or accesses one of up to 2^{m} headers of data packets stored in the memory (1), the unmodified address bus signal (5) comprising m+n bits and the modified address bus signal (5) comprising m+n+k bits.

11. Method according to one of Claims 1 to 10, **characterized in that** the second process (#2) locks the second stage (7) of the control register (4) if necessary, with the result that copying of the content of the first stage (6) of the control register (4) to the second stage (7) is prevented.

12. Method according to Claim 11, **characterized in that** the content of the first stage (6) of the control register (4) is copied to the second stage (7) of the control register (4) if the second stage (7) is unlocked.

13. Method according to Claim 12, **characterized in that** the content of the second stage (7) of the control register (4) is inserted into the address bus signal (5).

14. Communication module (31) which is connected to a communication medium (30) and belongs to a subscriber (32) of a communication system (33), the module (31) having a message memory (1) for buffering messages received via the medium (30) or to be transmitted via the medium, **characterized in that** the communication module (31) has means for controlling access to areas of the message memory (1) from a subscriber processor (34) in accordance with a method according to one of Claims 1 to 13.

## Revendications

1. Procédé de commande d'un accès à des zones d'une mémoire (1) depuis plusieurs processus (2),
un premier (#1) des processus (2) commandant une partie d'un bus d'adresse (3) avec lequel un autre (#2) des processus (2) accède à la mémoire (1),
par la commande de la partie du bus d'adresse (3), le premier processus (#1) influençant la zone de la mémoire à laquelle accède l'autre processus (#2),
des paquets de données étant déposés dans la mémoire (1),
**caractérisé en ce que** le premier processus (#1) commande une partie du bus d'adresse (3) par le biais d'un registre de contrôle (4),
un registre de contrôle (4) étant prévu pour chaque paquet de données déposé dans la mémoire (1),
les registres de contrôle (4) étant configurés à deux niveaux,
le premier processus (#1) pouvant écrire à tout moment dans le premier niveau (6) du registre de contrôle (4).

2. Procédé selon la revendication 1, **caractérisé en ce que** les paquets de données sont déposés dans la mémoire (1) à chaque fois dans au moins deux versions et la différence entre les diverses versions des paquets de données est faite par le registre de contrôle (4).

3. Procédé selon la revendication 1 ou 2, **caractérisé en ce que** la mémoire (1) est réalisée sous la forme d'une RAM à double port à laquelle les processus (#1, #2) accèdent simultanément.

4. Procédé selon la revendication 1 ou 2, **caractérisé en ce que** la mémoire (1) est réalisée sous la forme d'une RAM à port unique à laquelle les processus (#1, #2) accèdent en alternance, notamment en multiplexage temporel.

5. Procédé selon l'une des revendications 1 à 4, **caractérisé en ce que** des paquets de données de même taille sont déposés dans la mémoire (1), notamment de 2ⁿ mots de mémoire, avec *n* ∈ |N.

6. Procédé selon l'une des revendications 1 à 4, **caractérisé en ce que** des paquets de données de taille quelconque sont déposés dans la mémoire (1), les paquets de données étant respectivement fractionnés en deux parties, à savoir en une partie de tête, notamment de 2ⁿ mots de mémoire, avec *n* ∈ |N, et en une partie principale de taille variable, les parties de tête des différents paquets de données ayant la même taille.

7. Procédé selon la revendication 2, **caractérisé en ce que** le nombre de versions des paquets de données qui sont déposées dans la mémoire (1) est égal au nombre de processus (2) qui peuvent accéder à la mémoire (1).

8. Procédé selon la revendication 2 ou 7, **caractérisé en ce que** le premier processus (#1) peut accéder à toutes les zones de la mémoire (1) et modifie un signal de bus d'adresse (5) avec lequel l'autre processus (#2) accède à la mémoire (1), le signal de bus d'adresse (5) non modifié renvoyant à un paquet de données (10) précis déposé dans la mémoire (1) ou à une partie de tête d'un paquet de données (10) précis déposé dans la mémoire (1) et le signal de bus d'adresse (5) modifié renvoyant à une version (11) précise du paquet de données (10) ou de la partie de tête du paquet de données (10).

9. Procédé selon la revendication 8, **caractérisé en ce que** le signal de bus d'adresse non modifié comprend un nombre précis de bits d'adresse et le premier processus (#1), pour modifier le signal de bus d'adresse (5), ajoute au signal de bus d'adresse (5) non modifié au moins un bit d'adresse supplémentaire par le biais duquel la différence est faite entre les diverses versions (11) enregistrées du paquet de données (10) ou de la partie de tête du paquet de données (10).

10. Procédé selon la revendication 9, **caractérisé en ce que** le deuxième processus (#2) accède à un parmi un maximum de 2^{m} paquets de données déposés dans la mémoire (1) ou une parmi un maximum de 2^{m} parties de tête de paquets de données déposées dans la mémoire (1), le signal de bus d'adresse (5) non modifié comprenant m+n bits et le signal de bus d'adresse (5) modifié m+n+k bits.

11. Procédé selon l'une des revendications 1 à 10, **caractérisé en ce que** le deuxième processus (#2) verrouille au besoin le deuxième niveau (7) du registre de contrôle (4), de sorte qu'une copie du contenu du premier niveau (6) du registre de contrôle (4) dans le deuxième niveau (7) est inhibée.

12. Procédé selon la revendication 11, **caractérisé en ce que** le contenu du premier niveau (6) du registre de contrôle (4) est copié dans le deuxième niveau (7) du registre de contrôle (4) lorsque le deuxième niveau (7) est déverrouillé.

13. Procédé selon la revendication 12, **caractérisé en ce que** le contenu du deuxième niveau (7) du registre de contrôle (4) est inséré dans le signal de bus d'adresse (5).

14. Module de communication (31) d'un abonné (32) d'un système de communication (33) raccordé à un support de communication (30), le module (31) présentant une mémoire de messages (1) pour le stockage temporaire de messages reçus par le biais du support (30) ou à envoyer par le biais du support, **caractérisé en ce que** le module de communication (31) présente des moyens pour commander un accès à des zones de la mémoire de messages (1) depuis un processeur d'abonné (34) conformément à un procédé selon l'une des revendications 1 à 13.
